# EUROPÄISCHE PATENTSCHRIFT

(11) **EP 3 863 803 B1**
(45) Veröffentlichungstag und Bekanntmachung des Hinweises auf die Patenterteilung: **18.05.2022**
(21) Anmeldenummer: 18786260.2
(22) Anmeldetag: 08.10.2018
(51) Int. Cl.: B25D 17/24, B25D 9/02, B25D 9/08

(54) **DRUCKLUFTMEISSEL**
PNEUMATIC CHIPPING HAMMER
BURIN À AIR COMPRIMÉ

(43) Veröffentlichungstag der Anmeldung: 18.08.2021
(73) Patentinhaber: Wacker Chemie AG, 81737 München (DE)
(72) Erfinder: GRÜBL, Peter, 94428 Eichendorf (DE); BRIXEL, Martin, 84375 Kirchdorf (DE)
(74) Vertreter: Belz, Ferdinand
(86) Internationale Anmeldenummer: PCT/EP2018/077344
(87) Internationale Veröffentlichungsnummer: WO 2020/074058

(56) Entgegenhaltungen:
- US-A- 4 747 455
- US-A1- 2010 025 060

## Beschreibung

Die Erfindung betrifft einen Druckluftmeißel und eine zumindest einen solchen Druckluftmeißel umfassende Vorrichtung zum Zerkleinern von zumindest einem polykristallinen Siliciumstab.

Polykristallines Silicium (Polysilicium) wird üblicherweise durch das Siemens-Verfahren - ein chemischer Gasphasenabscheidungsprozess - hergestellt. Dabei werden in einem glockenförmigen Reaktor (Siemens-Reaktor) dünne Filamentstäbe (Dünnstäbe) aus Silicium durch direkten Stromdurchgang erhitzt und ein Reaktionsgas enthaltend eine siliciumhaltige Komponente und Wasserstoff eingeleitet. Die siliciumhaltige Komponente ist in der Regel Monosilan (SiH₄) oder ein Halogensilan der allgemeinen Zusammensetzung SiHₙX₄₋ₙ (n = 0, 1, 2, 3; X = Cl, Br, I). Üblicherweise handelt es sich um ein Chlorsilan oder Chlorsilangemisch, meist um Trichlorsilan (SiHCl₃, TCS). Der Aufbau eines typischen Siemens-Reaktors ist beispielsweise in der EP 2 077 252 A2 beschrieben.

Die Dünnstäbe werden von Elektroden, die im Reaktorboden verankert sind, aufgenommen. Üblicherweise werden jeweils zwei Dünnstäbe mit einer Brücke zu einem Dünnstabpaar verbunden, das über die Elektroden einen Stromkreis bildet. Die Oberflächentemperatur der Filamentstäbe beträgt üblicherweise mehr als 1000°C. Bei diesen Temperaturen zersetzt sich die siliciumhaltige Komponente des Reaktionsgases und elementares Silicium scheidet sich aus der Gasphase als Polysilicium auf der Staboberfläche ab. Dadurch nimmt der Durchmesser der Dünnstäbe zu. Nach dem Erreichen eines vorgegebenen Durchmessers wird die Abscheidung üblicherweise gestoppt und die erhaltenen U-förmigen Siliciumstäbe ausgebaut. Nach dem Entfernen der Brücke werden annähernd zylinderförmige Siliciumstäbe erhalten.

Polysilicium ist das Ausgangsmaterial bei der Produktion von einkristallinem Silicium, das beispielsweise mittels des Czochralski-Verfahrens (Tiegelziehen) hergestellt wird. Ferner wird Polysilicium zur Herstellung von multikristallinem Silicium, beispielsweise mittels Blockgussverfahren, benötigt. Für beide Verfahren muss das stabförmige Polysilicium zunächst in Bruchstücke zerkleinert werden. Die Reinheit des Polysiliciums ist für diese Folgeverfahren von entscheidender Bedeutung, da Kontaminationen in der Regel zu Versetzungsfehlern (eindimensionale, d.h. linienförmige Störungen) und Stapelfehlern (zweidimensionale, d.h. flächenhafte Störungen) im Kristallaufbau führen. Beide Phänomene verringern die Ausbeute, da sich grundsätzlich nur Siliciumkristalle zum Einsatz in der Photovoltaik- und Elektronikindustrie eignen, die eine bestimmte Kristallfehleranzahl nicht überschreiten.

Es sind verschiedene Verfahren zur Zerkleinerung von Polysiliciumstäben bekannt.

CN102600948A beschreibt eine Anlage zum vollautomatischen Zerkleinern von Polysiliciumstäben. Die Anlage umfasst neben einer Zerkleinerungseinheit eine Transportvorrichtung, mit welcher die Stäbe jeweils entlang ihrer Längsachse der Zerkleinerungsvorrichtung zugeführt werden. Die Zerkleinerung erfolgt von zwei Seiten aus durch zwei Batterien von entlang der Längsachse angeordneter Meißel. Nachteilig hier ist, dass die Position der Meißel nicht an über die Stablänge variierende Durchmesser angepasst werden kann.

US2010/025060A1 beschreibt ein handgeführtes pneumatisches Brechwerkzeug, bei dem ein Kolben in einem Führungsrohr mittels Druckluft auf einen am Ende des Führungsrohres angeordneten Hammerkopf beschleunigt wird (Hammer-Meißel-Prinzip). EP2308598A1 beschreibt eine Zerkleinerungsvorrichtung mit einer entlang der Stablängsachse verschiebbaren Einheit, die mehrere Schlageinheiten trägt, welche in unterschiedlichen Winkeln zueinander angeordnet sind. Die Schlageinheiten beruhen auf dem Hammer-Meißel-Prinzip. Das zerkleinerte Polysilicium wird in einer Bruchwanne abgeführt.

US2006/243834A beschreibt eine Vorrichtung zum Zerkleinern eines Polysiliciumstabs, bei der sich der Stab auf einer höhenverstellbaren Unterlage befindet und dort zwischen Zerkleinerungsmeißeln und Gegenmeißeln derart justiert wird, dass alle Meißel in Kontakt mit dem Siliciumstab stehen. Das zerkleinerte Polysilicium wird mittels einer unterhalb der Unterlage angeordneten Wanne abgeführt. Nachteilig hier ist, dass es aufgrund der relativ hohen Fallhöhe des zerkleinerten Siliciums zu einer Nachzerkleinerung kommen kann.

US4747455A beschreibt ein Zerkleinerungswerkzeug, bei welchem ein mittels Schwungrädern angetriebener Kolben auf das hintere Ende eines Meißel beschleunigt wird und so den für die Zerkleinerung notwendigen Impuls überträgt.

Den bekannten Verfahren gemeinsam ist, dass sie eine kontaminationsarme Zerkleinerung von Polysiliciumstäben nicht gewährleisten können. Ein wesentliches Problem ist die zweiteilige Ausführung der Schlageinheiten. Diese sind nach dem Hammer-Meißel-Prinzip aufgebaut, das heißt, der in der Regel pneumatisch beschleunigte Kolben ist von dem auf das Polysilicium treffenden Meißel entkoppelt. Dies hat einen erhöhten Abrieb zur Folge und damit auch eine erhöhte Kontamination des zerkleinerten Polysiliciums. Ferner sind die bekannten Schlageinheiten grundsätzlich als oszillierende Systeme ausgeführt. Auch die Oszillationsbewegung der zwei entkoppelten Komponenten (Kolben und Meißel) ist mit einem hohen Abrieb verbunden. Zudem ist die Lebensdauer der Komponenten unbefriedigend.

Gegenwärtig ist zerkleinertes Polysilicium mit der geringsten Kontamination ausschließlich durch manuelle Zerkleinerung zu erhalten. Dabei wird das Silicium üblicherweise mit gezielten, wenigen Hammerschlägen gebrochen. Die manuelle Zerkleinerung ist mit einer erheblichen Belastung für die ausführende Person verbunden. Vor dem Hintergrund immer effizienter werdender Abscheideprozesse mit wachsenden Chargengrößen, Stablängen und -durchmessern ist eine manuelle Zerkleinerung wirtschaftlich und insbesondere auch aus gesundheitlichen Aspekten nicht mehr vertretbar. Aus dieser Problematik ergab sich die Aufgabenstellung der vorliegenden Erfindung.

Diese Aufgabe wird gelöst durch einen Druckluftmeißel, der sich insbesondere zum Zerkleinern von Polysilicium eignet, und folgende Komponenten umfasst:
- ein Gehäuse mit einem doppeltwirkenden pneumatischen Zylinder, in dem ein Kolben mit einem Meißel entlang einer Längsachse bewegbar angeordnet ist, wobei der Zylinder einen arbeitsseitigen Abschnitt und einen rückstellseitigen Abschnitt aufweist, wobei der rückstellseitige Abschnitt ein Dämpfungsmittel und eine Druckausgleichsöffnung umfasst und wobei der arbeitsseitige Abschnitt eine Endlagendämpfung und einen Druckluftanschluss umfasst,
- einen mit dem rückstellseitigen Abschnitt des Zylinders verbundenen Druckluftspeicher und
- ein Meißelführungsgehäuse mit einer Sperrluftkammer.

Mit besonderem Vorteil ermöglicht der Druckluftmeißel eine Zerkleinerung sowohl mittels Einzelschlag als auch mittels Mehrfachschlägen (oszillierend). Die Zerkleinerung mittels Einzelschlag verringert den Kontaminationseintrag in das Zerkleinerungsprodukt erheblich.

Bei dem Polysilicium handelt es sich insbesondere um einen Polysiliciumstab aus dem Siemens-Verfahren. Der Polysiliciumstab ist ein im Wesentlichen zylindrischer Körper mit einem im Wesentlichen kreisförmigen Querschnitt, der eine Längsachse und eine Querachse aufweist. Derzeit liegen typische Durchmesser eines solchen Polysiliciumstabs zwischen 100 und 280 mm. Typische Längen liegen zwischen 2 und 3 m. Allerdings ist die Eignung des Druckluftmeißels zur Zerkleinerung grundsätzlich unabhängig von den Abmessungen des Polysiliciums.

Bei der im arbeitsseitigen Abschnitt (oder arbeitsseitigen Ende) des Zylinders angeordneten Endlagendämpfung handelt es sich vorzugsweise um eine fluidische, insbesondere pneumatische, oder mechanische Endlagendämpfung. Besonders bevorzugt ist eine mechanische Endlagendämpfung, insbesondere in Form von zumindest einer Tellerfeder. Ferner kann es sich bei der mechanischen Endlagendämpfung auch um eine oder mehrere Dämpfungsscheiben handeln.

Gemäß einer bevorzugten Ausführungsform weist der arbeitsseitige Abschnitt des Zylinders ferner eine Druckausgleichsöffnung auf. Allerdings erfüllt in der Regel der Druckluftanschluss auch die Funktion einer Druckausgleichsöffnung.

Der Kolben ist mit dem Meißel einstückig ausgebildet. In anderen Worten, der Kolben ist mit dem Meißel unlösbar verbunden.

Bevorzugt weist der Meißel ein kalottenförmiges, insbesondere halbkreisförmiges, Ende auf. Dadurch wird eine Reduzierung der erforderlichen Zerkleinerungsenergie erzielt. Die Reduzierung der Zerkleinerungsenergie hat Auswirkungen auf die nachfolgende Produktkontamination sowie die Standzeit des Druckluftmeißels. Ferner können durch die Kalottenform des Meißelendes im Meißel auftretende kritische Spannungszustände reduziert werden. Die Auswahl der exakten Form erfolgt üblicherweise in Abhängigkeit des zu zerkleinernden Materials. Für die Zerkleinerung von Polysilicium ist die Kalottenform besonders bevorzugt.

Vorzugsweise besteht der Meißel und/oder der Kolben aus einem Material, das ausgewählt ist aus der Gruppe mit Sinterwerkstoff (Metallpulver), Metall, Metalllegierung, Hartmetall (z.B. Wolframcarbid in Kobalt- oder Nickelmatrix) und Kombinationen daraus. Bei dem Sinterwerkstoff kann es sich beispielsweise um Wolframcarbid handeln. Ferner kann auch der Zylinder und/oder das Meißelführungsgehäuse aus dem zuvor beschriebenen Material bestehen.

Der Meißel und/oder der Kolben können zumindest teilweise eine Beschichtung (z.B. Polytetrafluorethylen, Kohlefaser oder generell Beschichtungen, die mittels physikalischer Gasphasenabscheidung (PVD) aufgebracht werden) aufweisen. Dasselbe gilt für den Zylinder und/oder das Meißelführungsgehäuse.

Vorzugsweise ist das Meißelführungsgehäuse mit einem Kunststoff, insbesondere Polyurethan, gegen die Umgebung abgedichtet. Die Abdichtung erfolgt insbesondere im Bereich der Öffnung, durch welche der Meißel geführt wird.

Die Sperrluftkammer des Meißelführungsgehäuses verhindert mit besonderem Vorteil eine Kontamination des zu zerkleinernden Produkts. Die durch die Bewegung des Kolbens und des Meißels entstehenden Partikel werden über eine Öffnung der Sperrluftkammer abtransportiert bevor sie das Zerkleinerungsprodukt erreichen können.

Die der Erfindung zugrundeliegende Aufgabe wird ferner gelöst durch eine Vorrichtung zum Zerkleinern von zumindest einem polykristallinen Siliciumstab. Die Vorrichtung umfasst
- eine Stabauflage mit einem entlang einer Achse A beweglichen Teil und einem unbeweglichen Teil, wobei eine erste Auflagefläche des beweglichen Teils und eine zweite Auflagefläche des unbeweglichen Teils in einem Winkel von 70 bis 130° zueinander angeordnet sind,
- eine verschließbare Bruchkammer, in der die Stabauflage angeordnet ist und die eine Meißeldurchführung aufweist und
- mindestens einen beschriebenen Druckluftmeißel, der außerhalb der Bruchkammer an einem parallel zu einer Längsachse der Stabauflage verlaufenden Träger befestigt ist.

Vorzugsweise sind die erste Auflagefläche des beweglichen Teils und die zweite Auflagefläche des unbeweglichen Teils in einem Winkel von 80 bis 120°, insbesondere von 85 bis 110°, zueinander angeordnet. Besonders bevorzugt beträgt der Winkel etwa 90°.

Die Vorrichtung umfasst vorzugsweise 4 bis 10, besonders bevorzugt 11 bis 17, insbesondere 18 bis 25 Druckluftmeißel. Die Druckluftmeißel sind bevorzugt in einer Reihe angeordnet.

Vorzugsweise sind zumindest einige der Druckluftmeißel verschiebbar an dem Träger befestigt. Dadurch lässt sich der Abstand zwischen den Meißeln variieren und gegebenenfalls der Zerkleinerungsgrad einstellen. Außerdem kann es vorgesehen sein, dass der oder die Druckluftmeißel quer zu seiner/ihrer Längsachse schwenkbar ist/sind.

Ferner kann der Träger relativ zur Stabauflage beweglich ausgebildet sein. Vorzugsweise ist er in alle Raumrichtungen beweglich und ggf. um seine Längsachse schwenkbar.

Ebenso ist die Stabauflage bevorzugt relativ zum Träger beweglich ausgebildet. Die Stabauflage kann beispielsweise auch nur entlang ihrer Längsachse und/oder entlang einer weiteren Achse, insbesondere senkrecht zur Längsachse, verschiebbar ausgebildet sein. Besonders bevorzugt ist die Stabauflage in alle Raumrichtungen beweglich.

Durch die Beweglichkeit des Trägers und/oder der Stabauflage lässt sich zum einen der Abstand zwischen dem oder den Meißeln und dem zu zerkleinernden Siliciumstab exakt einstellen. So kann für verschiedene Stabdurchmesser jeweils eine optimale Position eingestellt werden. Zum anderen lässt sich der Anschlagpunkt des Meißels auf der Staboberfläche exakt festlegen. Auf diese Weise lässt sich insbesondere die Bruchgröße und die aufzuwendende Schlagenergie steuern.

Aufgrund ggf. auftretender Durchmesserunterschiede über die Siliciumstablänge, ist die beschriebene separate Positionierbarkeit der Druckluftmeißel sehr hilfreich und führt zu einem besonders homogenen Bruchergebnis. Durch die Fixierung und Ausrichtung des Siliciumstabs in der Stabauflage kann ferner eine Durchmesser- und Lageerkennung mittels berührungsloser Sensorik angewandt werden. Durch eine entsprechende Auswertung kann jeder Druckluftmeißel in Abhängigkeit der Stabdimensionen positioniert werden. Ferner können durch eine solche Sensorik sogenannte Freischläge vermieden und damit die Standzeit der Apparatur erhöht werden.

Vorzugsweise ist die Schlagabfolge der Druckluftmeißel mittels eines softwaregestützten Programms frei wählbar. Insbesondere kann auf Basis der beschriebenen Sensorik eine optimale Schlagabfolge in Abhängigkeit von Vorgabeparametern errechnet werden. Die Schlagabfolge kann insbesondere in Abhängigkeit von der Art des zu zerkleinernden Polysiliciums und/oder in Abhängigkeit von der gewünschten Bruchgröße variiert werden.

Gemäß einer bevorzugten Ausführungsform ist unter der Stabauflage eine Fördereinrichtung, insbesondere Förderband, zum Abtransport von Siliciumbruchstücken angeordnet. Die Fördereinrichtung verläuft vorzugsweise parallel zur Längsachse der Stabauflage. Nach dem Zerkleinerungsvorgang befinden sich die Siliciumbruchstücke in der Stabauflage. Die Stabauflage dient also auch als Bruchwanne. Durch Verschieben des entlang der Achse A beweglichen Teils der Stabauflage (Öffnen der Stabauflage) werden die Bruchstücke auf die Fördereinrichtung überführt. Aufgrund der Vermeidung einer Kippbewegung wird die potentielle Lageenergie des Bruchguts reduziert. Dies führt zu einer verminderten Abwurfhöhe in die Fördereinrichtung, so dass eine unerwünschte Nachzerkleinerung vermieden und die Standzeit von Auskleidungsmaterialien (insbesondere Silicium) erhöht wird.

Ferner bietet die zweiteilige Ausführung der Stabauflage die Möglichkeit, mit einem leicht geöffneten Spalt zwischen festen und beweglichen Teil zu zerkleinern. Dadurch kann während des Zerkleinerungsvorgangs ggf. vorhandener kontaminierter Staub aus der Bruchwanne abgeführt bzw. abgesaugt werden. Vorzugsweise ist unterhalb der Stabauflage eine regelbare Absaugung installiert.

Durch das Öffnen der Stabauflage wird der Bruchgutabwurf auf die Fördereinrichtung ausgelöst. Die Freigabe der Öffnung wird vorzugsweise in Abhängigkeit des Füllgrads der Stabauflage ausgelöst. Dabei kann die Bruchgutmenge des vorausgegangenen Zerkleinerungsvorgangs herangezogen werden. So kann ein Abwurf auf bereits gebrochenes Polysilicium auf der Fördereinrichtung und damit eine unerwünschte Nachzerkleinerung vermieden werden.

Vorzugsweise weist die erste Auflagefläche und/oder die zweite Auflagefläche der Stabauflage Querverstrebungen (senkrecht zur Längsachse der Stabauflage) auf. Die Querverstrebungen der ersten Auflagefläche des beweglichen Teils können gegenüber den Querverstrebungen der Auflagefläche des unbeweglichen Teils versetzt angeordnet sein. Dadurch kann ein besseres Zerkleinerungsergebnis erzielt werden.

Die Stabauflage weist im Querschnitt bevorzugt ein Hohlkammerprofil auf, das beispielsweise mit Beton, insbesondere Polymerbeton, gefüllt sein kann. Dies führt zu einer verringerten Eigenschwingung und besseren Dämpfungseigenschaften.

Gemäß einer weiteren Ausführungsform ist die Bruchkammer mit einer Schiebe-, Klapp-, oder Falltür verschließbar, um das Eindringen von Staub zu verhindern. Vorzugsweise verschließt sich die Bruchkammer automatisch bevor der Zerkleinerungsprozess stattfindet.

Die Bruchkammer kann ferner mit einer Absaugeinrichtung verbunden sein, die insbesondere während des Zerkleinerungsprozesses aktiviert ist.

Die Meißeldurchführung der Bruchkammer ist vorzugsweise mit einem Kunststoff, insbesondere Polyurethan, abgedichtet. Ferner kann es bevorzugt sein, die Bruchkammer durch Erzeugen eines Überdrucks gegen das Eindringen von Staub zu sichern.

Durch die geschlossene Bruchkammer kann gezielt die Luftzirkulation gesteuert werden. So kann während des Zerkleinerungsvorgangs aufgewirbelter ggf. kontaminierter Staub abgesaugt und ein Kontaminationseintrag von außen vermieden werden.

Gemäß einer weiteren Ausführung schließt sich an die Bruchkammer ein Materialvorlagetisch an. Dieser ist bevorzugt durch die Schiebe-, Klapp-, oder Falltür von der Bruchkammer getrennt. Auf dem Materialvorlagetisch kann während des Zerkleinerungsvorgangs bereits ein neuer Siliciumstab positioniert werden, so dass eine besonders effiziente Arbeitsweise möglich ist. Ggf. kann auf dem Vorlagetisch eine manuelle Vorzerkleinerung stattfinden. Der Vorlagetisch ist vorzugsweise bis auf eine Zugangsöffnung auf einer Seite ebenfalls eingehaust und kann ggf. mit einer Absaugung ausgestattet sein.

Sämtliche Auskleidungsteile der Vorrichtung, insbesondere solche, die mit dem Polysilicium in Kontakt treten, sind vorzugsweise aus einem abriebfesten Material wie beispielsweise Hartmetalle, Kunststoffe (z.B. Polyurethane) oder auch Silicium.

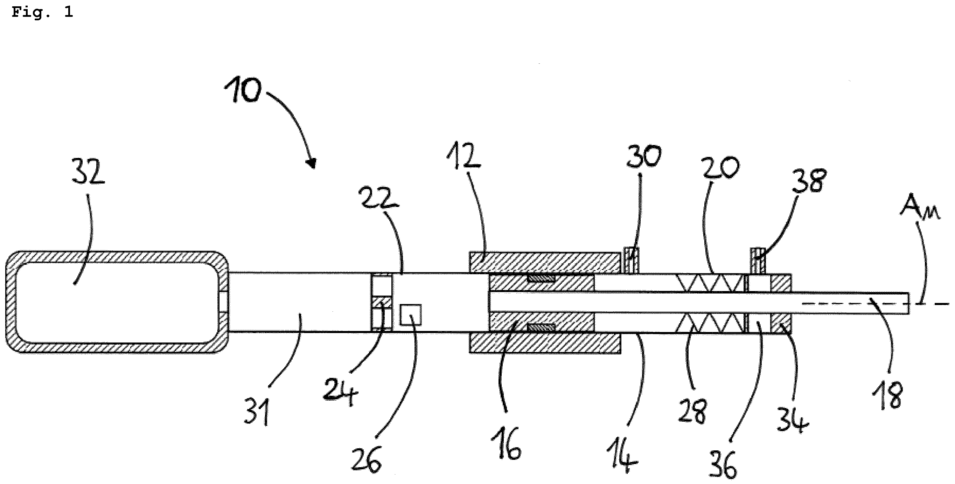

**Fig. 1** zeigt einen erfindungsgemäßen Druckluftmeißel 10 im Querschnitt. Der Druckluftmeißel 10 umfasst ein Gehäuse 12, das zumindest teilweise einen Zylinder 14 umgibt. Der Zylinder 14 kann auch ganz mit dem Gehäuse 12 umgeben sein. In dem Zylinder 14 ist ein entlang einer Achse A_{M} beweglicher Kolben 16 mit einem Meißel 18 angeordnet. Der Kolben 16 und der Meißel 18 bilden eine Einheit (einstückig ausgebildet) und sind aus Wolframcarbid gefertigt. Der Zylinder 14 hat einen arbeitsseitigen Abschnitt 20, der in Richtung des zu zerkleinernden Objekts zeigt, und einen davon abgewandten rückstellseitigen Abschnitt 22. Im arbeitsseitigen Abschnitt 22 ist eine Endlagendämpfung 28 angeordnet, bei der es sich um eine Tellerfeder handelt. Ferner verfügt der arbeitsseitige Abschnitt 22 über einen Druckluftanschluss 30, der auch als Druckausgleichsöffnung fungiert. Im rückstellseitigen Abschnitt 22 befindet sich eine Dämpfungsscheibe als Dämpfungsmittel 24. Des Weiteren ist der rückstellseitige Abschnitt 22 mit einer Druckausgleichsöffnung 26 versehen und über ein Verbindungsstück 31 mit einem Druckluftspeicher 32 verbunden. An den arbeitsseitigen Abschnitt 22 des Zylinders schließt sich ein Meißelführungsgehäuse 34 mit einer Sperrluftkammer 36 und einer Öffnung 38 an.

In der Fig. 1 befindet sich der Kolben 16 in einer Mittelstellung zwischen einer Rückstell- und einer Endlagenposition. Zu Beginn eines Zerkleinerungsschlags befindet sich der Kolben 16 üblicherweise am Anschlag des Dämpfungsmittels 24 (Rückstellposition). Der Druckluftspeicher 32 wird in Abhängigkeit des zu zerkleinernden Materials mit einer vorgegebenen Menge Druckluft befüllt. Nach dem Erreichen des Drucksollwerts wird ein im Druckluftspeicher 32 integriertes Ventil geöffnet, wodurch die Druckluft schlagartig über das Verbindungsstück 31 in den Zylinder 14 gelangt und den Kolben 16 in Richtung Endlagendämpfung 28 beschleunigt. Der Meißel 18 führt infolgedessen einen Einzelschlag auf das zu zerkleinernde Material aus. Der Kolben 16 kommt in der Endlagenposition am Anschlag der Endlagendämpfung 28 zum Stillstand. Die überschüssige Druckluft kann über die Öffnungen 30, 26 entweichen. Ggf. durch die Bewegung von Kolben 16 und Meißel 18 entstandene Abriebpartikel werden über die Öffnung 38 der Sperrluftkammer 36 abtransportiert bevor sie das zerkleinerte Material erreichen können.

Für einen erneuten Schlag wird über den Druckluftanschluss 30 eine geringe Menge Druckluft in den Zylinder 14 eingebracht, die den Kolben 16 wieder in die Rückstellposition befördert. Bei dem Zylinder 14 handelt es sich also um einen doppeltwirkenden pneumatischen Zylinder. Durch präzise Taktung der Druckluftzufuhr aus dem Speicher 32 und dem Anschluss 30 kann der Kolben 16/Meißel 18 in eine oszillierende Bewegung versetzt werden, ohne dabei allerdings die Nachteile des Hammer-Meißel-Prinzips von aus dem Stand der Technik hinlänglich bekannten Zerkleinerern zu zeigen.

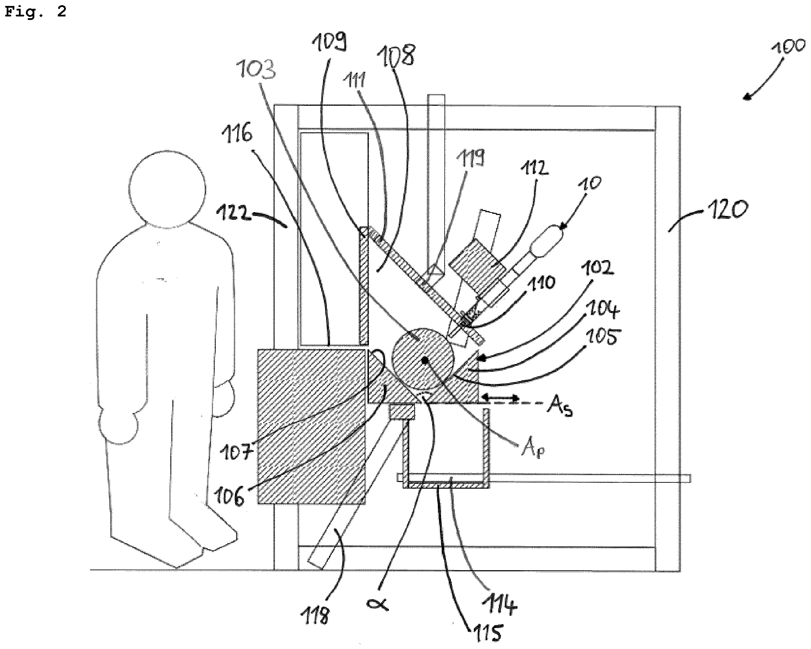

**Fig. 2** zeigt den Querschnitt einer erfindungsgemäßen Vorrichtung 100 zum Zerkleinern von polykristallinen Siliciumstäben. Die Vorrichtung 100 umfasst eine Stabauflage 102, die ein unbewegliches Teil 106 und ein entlang der Achse (oder Ebene) A_{S} verschiebbares bewegliches Teil 104 umfasst. Der bewegliche Teil 104 hat eine erste Auflagefläche 105, die zu einer zweiten Auflagefläche 107 des unbeweglichen Teils 106 in einem Winkel α von 90° angeordnet ist. Die Auflageflächen 105, 107 bilden eine Mulde, in welcher ein Polysiliciumstab 103 mit einer Längsachse A_{P} angeordnet und fixiert ist. Die Achse A_{P} verläuft parallel zur Längsachse der Stabauflage 102. Der Siliciumstab befindet sich in einer Bruchkammer 108, die durch ein Schott 109 verschlossen werden kann.

Außerhalb der Bruchkammer 108 sind 21 Druckluftmeißel 10 (vgl. Fig. 1) in einer Reihe (parallel ihrer Längsachsen A_{M}) an einem Träger 112 befestigt. Ein optimaler Abstand der Druckluftmeißel 10 zueinander kann im Bereich von 5 und 15 cm (gemessen zwischen den Meißelenden) liegen. Eine Wandung 111 der Bruchkammer 108 hat eine Meißeldurchführung 110, die mit einem Polyurethankunststoff ausgekleidet ist, um das Eindringen von Staub zu verhindern. Ferner mündet in die Wandung 111 eine Absaugeinrichtung 119.

Unterhalb der Stabauflage 102 ist eine Fördereinrichtung 114 zum Abtransport von Siliciumbruchstücken sowie eine weitere Absaugung 118 angeordnet. Um Kontaminationen vorzubeugen, befindet sich die Fördereinrichtung 114 in einer Einhausung 115.

Vor dem Schott 109, das die Bruchkammer 108 verschließt, befindet sich ein Materialvorlagetisch 116. Die gesamte Vorrichtung 100 wird von einem Gehäuse 120 umschlossen, das an einer Zutrittsseite 122 geöffnet ist.

Zum Zerkleinern von Siliciumstäben wird zunächst ein Siliciumstab 103 auf den Materialvorlagetisch 116 befördert. Dies kann beispielsweise händisch oder mit einem Kran erfolgen. Ggf. kann auf dem Vorlagetisch 116 eine Vorzerkleinerung stattfinden. Der Stab 103 wird dann bei geöffnetem Schott 109 in die Stabauflage 102 gerollt. Das Schott 109 schließt sich und die Bruchkammer 108 ist nun im Wesentlichen hermetisch abgeriegelt. Auf dem Materialvorlagetisch 116 wird nun in der Regel bereits der nächste Stab 103 vorgelegt.

Mit Hilfe von Sensoren (z.B. Laserscan) wird der Stab 103 vermessen, um die optimale Position der 21 Druckluftmeißel 10 einzustellen. Diese hängt insbesondere vom Durchmesser des Stabs aber auch vom gewünschten Zerkleinerungsgrad und der Art des Siliciums ab. Hier spielt insbesondere die Morphologie des Siliciums eine Rolle. Beispielsweise wird zwischen porösen Siliciumstäben (Solarstandard) und kompakten Stäben (SEMI Standard), die eine hohe Eigenspannung aufweisen können, unterschieden. Der Stab 103 wird nun durch Verfahren der Stabauflage 102 an die Meißel 18 herangefahren. Eine Feinjustierung jedes einzelnen Druckluftmeißels 10 kann ebenfalls erfolgen. Ein optimaler Abstand zwischen Staboberfläche und Meißel 18 liegt üblicherweise in einem Bereich von 5 und 30 mm. Mit besonderem Vorteil ist es nicht erforderlich, dass die Meißel 18 vor dem Zerkleinern in Kontakt mit dem Stab 103 stehen. Ferner wird in Abhängigkeit des Durchmessers, des gewünschten Zerkleinerungsgrads und der Siliciumart die Druckluftmenge und damit die Schlagstärke eingestellt. Typische Werte liegen hier in einem Bereich von 150 Joule bis 700 Joule. Nachdem die Druckluftmeißel 10 ausgelöst wurden, wobei ein Einzelschlag jedes Druckluftmeißels 10 in der Regel genügt, wird der bewegliche Teil 104 der Stabauflage 102 geöffnet und das zerkleinerte Silicium in die Fördereinrichtung 114 überführt. Während des Zerkleinerungsvorgangs sind die Absaugungen 119, 118 grundsätzlich aktiviert. Das zerkleinerte Silicium wird abtransportiert und üblicherweise einer Verpackungsvorrichtung zugeführt. Unmittelbar nachdem die Stabauflage 102 wieder geschlossen ist, öffnet sich das Schott 109 für die Aufnahme des nächsten Stabs 103. In der Regel dauert die Zerkleinerung eines Stabs 103 (gemessen von der Ablage auf dem Materialvorlagetisch 116 bis zur erneuten Öffnung des Schotts 109) 10 bis 40 Sekunden.

## Patentansprüche

1. Druckluftmeißel, insbesondere zum Zerkleinern von polykristallinem Silicium, umfassend
- ein Gehäuse mit einem doppeltwirkenden pneumatischen Zylinder, in dem ein Kolben mit einem Meißel entlang einer Längsachse bewegbar angeordnet ist, wobei der Zylinder einen arbeitsseitigen Abschnitt und einen rückstellseitigen Abschnitt aufweist, wobei der rückstellseitige Abschnitt ein Dämpfungsmittel und eine Druckausgleichsöffnung umfasst und wobei der arbeitsseitige Abschnitt eine Endlagendämpfung und einen Druckluftanschluss umfasst,
- einen mit dem rückstellseitigen Abschnitt des Zylinders verbundenen Druckluftspeicher,
- ein Meißelführungsgehäuse mit einer Sperrluftkammer,
**dadurch gekennzeichnet, dass** der Kolben mit dem Meißel einstückig ausgebildet ist.

2. Druckluftmeißel nach Anspruch 1, **dadurch gekennzeichnet, dass** es sich bei der Endlagendämpfung um eine fluidische, insbesondere pneumatische, oder mechanische Endlagendämpfung handelt.

3. Druckluftmeißel nach Anspruch 1 oder 2, **dadurch gekennzeichnet, dass** der arbeitsseitige Abschnitt eine Druckausgleichsöffnung aufweist.

4. Druckluftmeißel nach einem der vorhergehenden Ansprüche,
**dadurch gekennzeichnet, dass** der Meißel und/oder der Kolben aus einem Material bestehen ausgewählt aus der Gruppe mit Sinterwerkstoff, Metall, Metalllegierung und Kombinationen daraus.

5. Druckluftmeißel nach einem der vorhergehenden Ansprüche,
**dadurch gekennzeichnet, dass** der Meißel und/oder der Kolben zumindest teilweise eine Beschichtung aufweisen.

6. Druckluftmeißel nach einem der vorhergehenden Ansprüche,
**dadurch gekennzeichnet, dass** das Meißelführungsgehäuse mit einem Kunststoff, insbesondere Polyurethan, gegen die Umgebung abgedichtet ist.

7. Vorrichtung zum Zerkleinern von zumindest einem polykristallinen Siliciumstab, umfassend
- eine Stabauflage mit einem entlang einer Achse A_{S} beweglichen Teil und einem unbeweglichen Teil, wobei eine erste Auflagefläche des beweglichen Teils und eine zweite Auflagefläche des unbeweglichen Teils in einem Winkel von 70° bis 130° zueinander angeordnet sind,
- eine verschließbare Bruchkammer, in der die Stabauflage angeordnet ist und die eine Meißeldurchführung aufweist,
- mindestens einen Druckluftmeißel nach einem oder mehreren der Ansprüche 1 bis 6, der außerhalb der Bruchkammer an einem parallel zu einer Längsachse der Stabauflage verlaufenden Träger befestigt ist.

8. Vorrichtung nach Anspruch 7, umfassend 4 bis 10, bevorzugt 11 bis 17, besonders bevorzugt 18 bis 25 Druckluftmeißel.

9. Vorrichtung nach Anspruch 7 oder 8, **dadurch gekennzeichnet, dass** der oder die Druckluftmeißel zumindest teilweise verschiebbar an dem Träger befestigt sind.

10. Vorrichtung nach einem der Ansprüche 7 bis 9, **dadurch gekennzeichnet, dass** der Träger relativ zur Stabauflage beweglich ist.

11. Vorrichtung nach einem der Ansprüche 7 bis 10, **dadurch gekennzeichnet, dass** die Stabauflage relativ zum Träger beweglich ist.

12. Vorrichtung nach einem der Ansprüche 7 bis 11, **dadurch gekennzeichnet, dass** unter der Stabauflage eine Fördereinrichtung zum Abtransport von Siliciumbruchstücken angeordnet ist.

13. Vorrichtung nach einem der Ansprüche 7 bis 12, **dadurch gekennzeichnet, dass** sich an die Bruchkammer ein Materialvorlagetisch anschließt.

14. Vorrichtung nach einem der Ansprüche 7 bis 13, **dadurch gekennzeichnet, dass** die Bruchkammer mit zumindest einer Absaugeinrichtung verbunden ist.

## Claims

1. Pneumatic chisel, in particular for comminuting polycrystalline silicon, comprising
- a housing having a double-acting pneumatic cylinder in which a piston comprising a chisel is movably arranged along a longitudinal axis, wherein the cylinder has a work-side section and a return-side section, wherein the return-side section comprises a damping means and a pressure-equalization opening and wherein the work-side section comprises an end-position damping means and a compressed air connection,
- a compressed air reservoir connected to the return-side section of the cylinder,
- a chisel guide housing comprising a sealing air chamber, **characterized in that** the piston is constructed as one piece with the chisel.

2. Pneumatic chisel according to Claim 1, **characterized in that** the end-position damping means is a fluidic, in particular pneumatic, or mechanical end-position damping means.

3. Pneumatic chisel according to Claim 1 or 2, **characterized in that** the work-side section comprises a pressure-equalization opening.

4. Pneumatic chisel according to any of the preceding claims, **characterized in that** the chisel and/or the piston are made of a material selected from the group comprising sintered material, metal, metal alloy and combinations thereof.

5. Pneumatic chisel according to any of the preceding claims, **characterized in that** the chisel and/or the piston at least partially comprise a coating.

6. Pneumatic chisel according to any of the preceding claims, **characterized in that** the chisel guide housing is sealed to the environment with a plastic, in particular polyurethane.

7. Apparatus for comminuting at least one polycrystalline silicon rod, comprising
- a rod cradle having a portion movable along an axis A_{S} and an immovable portion, wherein a first cradle surface of the movable portion and a second cradle surface of the immovable portion are arranged at an angle of 70° to 130° to one another,
- a sealable breaking chamber in which the rod cradle is arranged and which comprises a chisel feedthrough,
- at least one pneumatic chisel according to one or more of Claims 1 to 6 which is mounted externally to the breaking chamber on a carrier running parallel to a longitudinal axis of the rod cradle.

8. Apparatus according to Claim 7, comprising 4 to 10, preferably 11 to 17, particularly preferably 18 to 25, pneumatic chisels.

9. Apparatus according to Claim 7 or 8, **characterized in that** the pneumatic chisel (s) is/are at least partially displaceably mounted on the carrier.

10. Apparatus according to any of Claims 7 to 9, **characterized in that** the carrier is movable relative to the rod cradle.

11. Apparatus according to any of Claims 7 to 10, **characterized in that** the rod cradle is movable relative to the carrier.

12. Apparatus according to any of Claims 7 to 11, **characterized in that** a conveying means for transporting away silicon chunks is arranged below the rod cradle.

13. Apparatus according to any of Claims 7 to 12, **characterized in that** a material receiver table is attached to the breaking chamber.

14. Apparatus according to any of Claims 7 to 13, **characterized in that** the breaking chamber is connected to at least one extractor.

## Revendications

1. Burin à air comprimé, notamment pour le broyage de silicium polycristallin, comprenant
- un boîtier doté d'un cylindre pneumatique à double effet, dans lequel un piston doté d'un burin est agencé de manière mobile le long d'un axe longitudinal, le cylindre présentant une section côté travail et une section côté rappel, la section côté rappel comprenant un moyen d'amortissement et une ouverture d'équilibrage de pression et la section côté travail comprenant un amortissement de fin de course et un raccord d'air comprimé,
- un accumulateur d'air comprimé relié à la section côté rappel du cylindre,
- un boitier de guidage de burin doté d'une chambre d'air d'arrêt,
**caractérisé en ce que** le piston est configuré d'un seul tenant avec le burin.

2. Burin à air comprimé selon la revendication 1, **caractérisé en ce que** l'amortissement de fin de course consiste en un amortissement de fin de course fluidique, notamment pneumatique, ou mécanique.

3. Burin à air comprimé selon la revendication 1 ou 2, **caractérisé en ce que** la section côté travail présente une ouverture d'équilibrage de pression.

4. Burin à air comprimé selon l'une quelconque des revendications précédentes, **caractérisé en ce que** le burin et/ou le piston sont constitués d'un matériau choisi dans le groupe comprenant un matériau fritté, un métal, un alliage métallique et des combinaisons de ceux-ci.

5. Burin à air comprimé selon l'une quelconque des revendications précédentes, **caractérisé en ce que** le burin et/ou le piston présentent au moins partiellement un revêtement.

6. Burin à air comprimé selon l'une quelconque des revendications précédentes, **caractérisé en ce que** le boîtier de guidage de burin est étanchéifié vis-à-vis de l'environnement avec une matière plastique, notamment du polyuréthane.

7. Dispositif pour le broyage d'au moins une barre de silicium polycristallin, comprenant
- un appui de barre doté d'une partie mobile le long d'un axe A_{S} et d'une partie immobile, une première surface d'appui de la partie mobile et une deuxième surface d'appui de la partie immobile étant agencées selon un angle de 70° à 130° l'une par rapport à l'autre,
- une chambre de fragmentation pouvant être fermée, dans laquelle est agencé l'appui de barre et qui présente un passage de burin,
- au moins un burin à air comprimé selon une ou plusieurs des revendications 1 à 6, qui est fixé à l'extérieur de la chambre de fragmentation sur un support s'étendant parallèlement à un axe longitudinal de l'appui de barre.

8. Dispositif selon la revendication 7, comprenant de 4 à 10, de préférence de 11 à 17, de manière particulièrement préférée de 18 à 25 burins à air comprimé.

9. Dispositif selon la revendication 7 ou 8, **caractérisé en ce que** le ou les burins à air comprimé sont fixés au moins partiellement de manière coulissante sur le support.

10. Dispositif selon l'une quelconque des revendications 7 à 9, **caractérisé en ce que** le support est mobile par rapport à l'appui de barre.

11. Dispositif selon l'une quelconque des revendications 7 à 10, **caractérisé en ce que** d'appui de barre est mobile par rapport au support.

12. Dispositif selon l'une quelconque des revendications 7 à 11, **caractérisé en ce qu'**un appareil de transport pour l'évacuation de fragments de silicium est agencé sous l'appui de barre.

13. Dispositif selon l'une quelconque des revendications 7 à 12, **caractérisé en ce qu'**une table de présentation du matériau se trouve à la suite de la chambre de fragmentation.

14. Dispositif selon l'une quelconque des revendications 7 à 13, **caractérisé en ce que** la chambre de fragmentation est reliée à au moins un appareil d'aspiration.
